# EUROPEAN PATENT APPLICATION

(11) **EP 4 707 919 A1**
(43) Date of publication of application: **11.03.2026**
(21) Application number: 24823065.8
(22) Date of filing: 03.04.2024
(51) Int. Cl.: G03F 1/84, G03F 7/20, H05G 2/00

(54) **PLASMA GENERATION MECHANISM AND LIGHT SOURCE DEVICE**

(30) Priority: 12.06.2023 JP 2023096232
(71) Applicant: Ushio Denki Kabushiki Kaisha, Tokyo, 1080073 (JP)
(72) Inventor: GOTO, Naoki, Tokyo 100-8150 (JP)
(74) Representative: Maiwald GmbH
(86) International application number: PCT/JP2024/013690
(87) International publication number: WO 2024/257442

(57) **Abstract**

[Object] To provide a plasma generation mechanism and a light source apparatus that are capable of preventing the accumulation of debris caused by plasma generation.

[Solving Means] A plasma generation mechanism according to an embodiment of the present invention is a plasma generation mechanism included in a light source apparatus that extracts radiation by converting a liquid plasma raw material into plasma by application of an energy beam, the plasma generation mechanism including: a rotation body; a rotational drive source; a raw material supply section; a shielding portion; a heating mechanism; and a liquid guide portion. The rotation body has a rotation surface that rotates around a rotation axis. The rotational drive source causes the rotation body to rotate around the rotation axis. The raw material supply section supplies the plasma raw material to the rotation surface. The shielding portion faces an irradiation position of the rotation surface to be irradiated with the energy beam. The heating mechanism heats the shielding portion to a temperature equal to or higher than a melting point of the plasma raw material. The liquid guide portion guides, to the raw material supply section, the plasma raw material flowed in from the shielding portion.

## Description

### Technical Field

The present invention relates to a plasma generation mechanism and a light source apparatus that supply a plasma raw material to an energy beam irradiation position to generate plasma.

### Background Art

X-rays have been conventionally used for medical, industrial and research applications. In the medical field, X-rays are used for such applications as chest radiography, dental radiography, and computed tomography (CT). In the industrial field, X-rays are used for such applications as non-destructive testing and tomographic non-destructive testing to observe the inside of materials such as structures and welds. In the research field, X-rays are used for such applications as X-ray diffraction to analyze the crystal structure of materials and X-ray spectroscopy (X-ray fluorescence analysis) to analyze the constituent elements of materials. Extreme ultraviolet light (hereinafter, also referred to as "EUV light") having a wavelength of 13.5 nm, which is in the soft X-ray region having a relatively long wavelength among X-rays, has been recently used for exposure light.

Some EUV light source apparatuses that generate EUV generate high-temperature plasma by applying an energy beam to a plasma raw material such as molten tin or lithium to excite the plasma raw material and extract EUV light from the high-temperature plasma. A method of using a laser beam as an energy beam is called laser produced plasm (LPP), and a method of using discharge is called discharge produced plasma (DPP) or laser assisted discharge produced plasma (LDP).

Known LPP-type EUV light source apparatuses generate plasma by collecting a laser beam on liquid droplets of the plasma raw material to excite the raw material. Meanwhile, in recent years, a method of supplying a plasma raw material to a laser beam irradiation region using the centrifugal force of a rotation body has been developed (see, for example, Patent Literature 1). In this method, the rotation body rotates while the lower part thereof is immersed in the stored plasma raw material, thereby causing the plasma raw material to adhere to the rotation body surface and supplying the plasma raw material to the irradiation region on the rotation body surface. Since this method does not need to supply a plasma raw material in the form of liquid droplets, it is possible to obtain high-intensity radiation with a relatively simple configuration as compared with a method of collecting a laser beam on liquid droplets.

### Citation List

### Patent Literature

Patent Literature 1: Japanese Patent Application Laid-open No. 2014-216286

### Disclosure of Invention

### Technical Problem

However, when a laser beam is applied to the plasma raw material, debris, which is vapor and fumes of the plasma raw material, is generated together with plasma. When a laser beam is applied to the rotation body surface to which the plasma raw material has been applied as described in Patent Literature 1, a large amount of debris belches out in the direction normal to the rotation body surface and adheres to the region of the cover of the rotation body facing the irradiation region (hereinafter, a facing region).

The stored plasma raw material is heated by a heater and melted, but the heat is difficult to reach the vicinity of the facing region, causing the debris adhered to the facing region to solidify. If the amount of debris belched out is large, there is a possibility that the debris accumulates in the direction of its arrival, affecting the EUV light emission mechanism.

Further, of the plasma raw material adhered to the rotation body surface, the plasma raw material that has been irradiated with no laser beam returns to the reservoir and is reused. However, if the debris accumulates in the facing region, the plasma raw material in the amount corresponding thereto does not return to the reservoir, resulting in a decrease in the stored plasma raw material. In particular, when the irradiation frequency of the laser beam is high, the decrease amount of the plasma raw material increases, making it necessary to replenish early.

In view of the circumstances as described above, it is an object of the present invention to provide a plasma generation mechanism and a light source apparatus that are capable of preventing the accumulation of debris caused by plasma generation.

### Solution to Problem

In order to achieve the above-mentioned object, a plasma generation mechanism according to an embodiment of the present invention is a plasma generation mechanism included in a light source apparatus that extracts radiation by converting a liquid plasma raw material into plasma by application of an energy beam, the plasma generation mechanism including: a rotation body; a rotational drive source; a raw material supply section; a shielding portion; a heating mechanism; and a liquid guide portion.

The rotation body has a rotation surface that rotates around a rotation axis.

The rotational drive source causes the rotation body to rotate around the rotation axis.

The raw material supply section supplies the plasma raw material to the rotation surface.

The shielding portion faces an irradiation position of the rotation surface to be irradiated with the energy beam.

The heating mechanism heats the shielding portion to a temperature equal to or higher than a melting point of the plasma raw material.

The liquid guide portion guides, to the raw material supply section, the plasma raw material flowed in from the shielding portion.

With this configuration, the liquid plasma raw material is supplied to the rotation surface of the raw material supply section. When an energy beam is applied to the irradiation position on the rotation surface, plasma is generated and debris belches out. The debris reaches the shielding portion facing the irradiation position. However, since the shielding portion is heated to a temperature equal to or higher than the melting point of the plasma raw material, the debris that has reached the shielding portion melts into a liquid plasma raw material and returns to the raw material supply section via the liquid guide portion. Therefore, it is possible to reuse the plasma raw material that has become debris and reduce the frequency of replenishment of the plasma raw material. Further, since the debris does not accumulate on the shielding portion, it is possible to avoid the adverse effect of debris on radiation emission.

The raw material supply section may include a reservoir that stores the plasma raw material flowed in from the liquid guide portion, and
part of the rotation surface of the rotation body may be immersed in the plasma raw material stored in the reservoir.

The heating mechanism may be disposed on the shielding portion on a side opposite to the rotation body.

The heating mechanism may be adjacent to the reservoir.

The plasma generation mechanism may further include a cover that surrounds the rotation body and has a facing surface facing the rotation surface,
the facing surface may have an opening, and
the shielding portion may have a shielding surface facing the irradiation position via the opening.

The shielding surface may be farther away from the rotation surface than the facing surface.

The raw material supply section may include a reservoir that stores the plasma raw material flowed in from the liquid guide portion, and
the facing surface may match a peripheral edge of the reservoir when viewed from a direction perpendicular to the rotation axis.

The plasma generation mechanism may further include a cover that surrounds the rotation body and has a facing surface facing the rotation surface,
the facing surface may be located between the liquid guide portion and the raw material supply section, and
the liquid guide portion may cause the plasma raw material flowed in from the shielding portion to flow onto the facing surface.

The shielding portion may have a shielding surface facing the irradiation position, and
the liquid guide portion may have a liquid guide surface that gradually approaches the rotation surface from the shielding surface toward the facing surface.

The liquid guide surface may be an inclined surface.

The liquid guide surface may be a curved surface.

The shielding surface may have a groove through which the plasma raw material flows.

The shielding surface and the liquid guide surface may each be a hemispherical surface located a certain distance from the irradiation position.

The plasma generation mechanism may further include: a cover that surrounds the rotation body and has a facing surface facing the rotation surface; and
a shielding body that includes the shielding portion and the liquid guide portion and is attachable/detachable to/from the cover.

The energy beam may be a laser beam.

The radiation may be extreme ultraviolet light or X-rays.

The plasma raw material may be tin, lithium, gadolinium, terbium, gallium, bismuth, or an alloy including at least one of these materials.

In order to achieve the above-mentioned object, a light source apparatus according to an embodiment of the present invention is a light source apparatus that extracts radiation by converting a liquid plasma raw material into plasma by application of an energy beam, the light source apparatus including: a plasma generation mechanism; and a beam source.

The plasma generation mechanism includes a rotation body having a rotation surface that rotates around a rotation axis, a rotational drive source that causes the rotation body to rotate around the rotation axis, a raw material supply section that supplies the plasma raw material to the rotation surface, a shielding portion that faces an irradiation position of the rotation surface to be irradiated with the energy beam, a heating mechanism that heats the shielding portion to a temperature equal to or higher than a melting point of the plasma raw material, and a liquid guide portion that guides, to the raw material supply section, the plasma raw material flowed in from the shielding portion.

The beam source causes the energy beam to enter the irradiation position.

### Advantageous Effects of Invention

According to the present invention, it is possible to provide a plasma generation mechanism and a light source apparatus that are capable of preventing the accumulation of debris caused by plasma generation.

### Brief Description of Drawings

[Fig. 1] Fig. 1 is a schematic diagram of a light source apparatus according to a first embodiment of the present invention.
[Fig. 2] Fig. 2 is an enlarged view of a partial configuration of the above light source apparatus.
[Fig. 3] Fig. 3 is a schematic diagram of a plasma generation mechanism included in the above light source apparatus.
[Fig. 4] Fig. 4 is a perspective view of a rotation body unit included in the above plasma generation mechanism.
[Fig. 5] Fig. 5 is a cross-sectional view of the above rotation body unit.
[Fig. 6] Fig. 6 is a cross-sectional view of the above rotation body unit.
[Fig. 7] Fig. 7 is an exploded perspective view of the above rotation body unit.
[Fig. 8] Fig. 8 is a perspective view of a second cover member included in the above rotation body unit.
[Fig. 9] Fig. 9 is a perspective view of the above second cover member.
[Fig. 10] Fig. 10 is a cross-sectional view of the above second cover member.
[Fig. 11] Fig. 11 is a cross-sectional view of the above rotation body unit.
[Fig. 12] Fig. 12 is a cross-sectional view of a partial configuration of the above rotation body unit.
[Fig. 13] Fig. 13 is a schematic diagram showing an operation of the above rotation body unit.
[Fig. 14] Fig. 14 is a perspective view of a rotation body unit having another configuration.
[Fig. 15] Fig. 15 is a cross-sectional view of the above rotation body unit.
[Fig. 16] Fig. 16 is a perspective view of a rotation body unit having another configuration.
[Fig. 17] Fig. 17 is a cross-sectional view of the above rotation body unit.
[Fig. 18] Fig. 18 is a cross-sectional view of a partial configuration of the above rotation body unit.
[Fig. 19] Fig. 19 is a perspective view of a rotation body unit having another configuration.
[Fig. 20] Fig. 20 is an enlarged perspective view of part of the above rotation body unit.
[Fig. 21] Fig. 21 is a cross-sectional view of the above rotation body unit.
[Fig. 22] Fig. 22 is a cross-sectional view of a partial configuration of the above rotation body unit.
[Fig. 23] Fig. 23 is a perspective view of a rotation body unit having another configuration.
[Fig. 24] Fig. 24 is an exploded perspective view of a shielding body included in the above rotation body unit.
[Fig. 25] Fig. 25 is a cross-sectional view of a partial configuration of the above rotation body unit.
[Fig. 26] Fig. 26 is a perspective view of a second cover member included in the above rotation body unit.

### Mode(s) for Carrying Out the Invention

### (First embodiment)

A light source apparatus according to a first embodiment of the present invention will be described.

### [Basic configuration of light source apparatus]

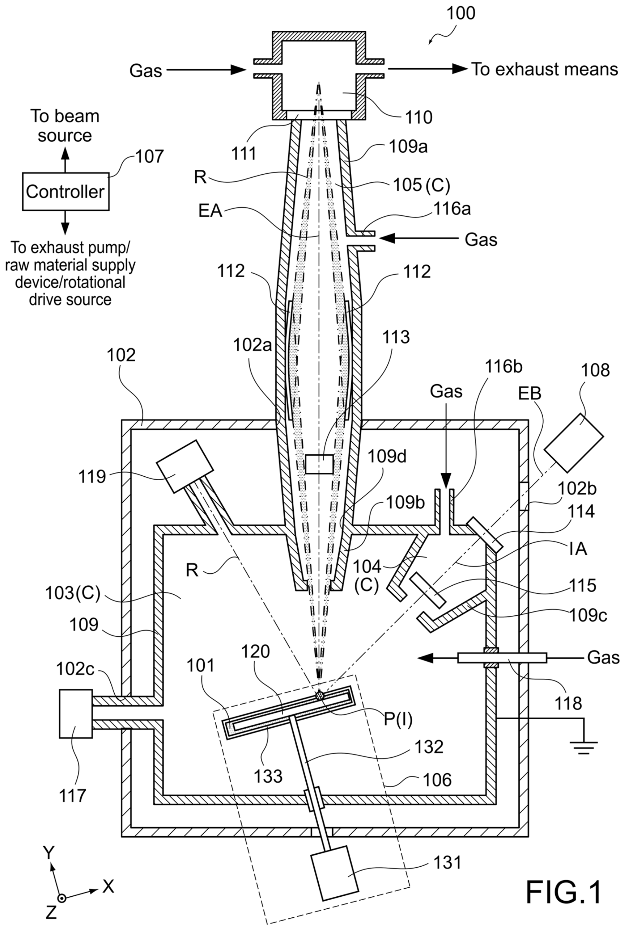

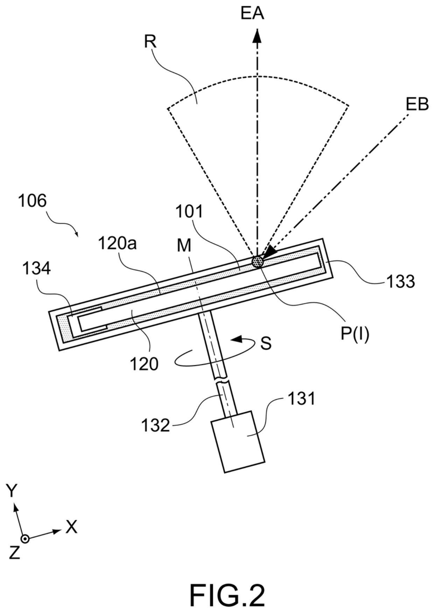

Fig. 1 is a schematic diagram showing a configuration example of a light source apparatus 100 according to this embodiment, and Fig. 2 is a schematic diagram showing an enlarged part of the light source apparatus 100. The light source apparatus 100 is a laser produced plasma (LPP)-based light source apparatus. That is, the light source apparatus 100 is an apparatus that generates plasma P by applying an energy beam EB to a plasma raw material 101 to excite the plasma raw material 101 as shown in Fig. 2, extracts radiation R emitted from plasma P, and uses the radiation R as a light source. The radiation R is extreme ultraviolet (EUV), X-rays, or other electromagnetic waves.

The plasma raw material 101 is tin (Sn), lithium (Li), gadolinium (Gd), terbium (Tb), gallium (Ga), bismuth (Bi), or an alloy including at least one of these materials and is liquid. In the case where EUV light is emitted as the radiation R, molten Sn or Li is used as the plasma raw material 101. In the case where X-rays are emitted as the radiation R, molten Ga, Ga alloy, Sn compound, or the like is used as the plasma raw material 101.

Fig. 1 illustrates a schematic cross section of the light source apparatus 100 when the light source apparatus 100 is cut along the horizontal direction at a predetermined height from its installation surface and viewed from vertically above. In Fig. 1, the illustration of the cross section is omitted for portions for which the configuration of the cross section does not need to be explained, in order to facilitate the understanding of the configuration and operation of the light source apparatus 100. In the following description, the X direction refers to the right-and-left direction (the positive side of the X axis is the right side, and the negative side is the left side) of the horizontal direction, the Y direction refers to the front-and-rear direction (the positive side of the Y axis is the front side, and the negative side is the rear side) of the horizontal direction, and the Z direction refers to the vertical direction (the positive side of the Z axis is the upper side, and the negative side is the lower side). Obviously, regarding the application of the present technology, the orientation in which the light source apparatus 100 is used, and the like are not limited.

As shown in Fig. 1, the light source apparatus 100 includes an enclosure 102, a vacuum chamber 103, an energy beam incident chamber 104, a radiation emission chamber 105, a plasma generation mechanism 106, a controller 107, and a beam source 108.

In the example shown in Fig. 1, the enclosure 102 is configured such that its external shape is approximately a cube. Note that the shape of the enclosure 102 is not limited to a cube and may be an arbitrary three-dimensional shape. The enclosure 102 includes an emission hole 102a formed in the front face of the enclosure 102, an incident hole 102b formed in the right side face thereof, and a through-hole 102c formed in the left side face thereof. The material of the enclosure 102 is not limited, and a metal is used, for example.

In this embodiment, an emission axis EA of the radiation R is set such that it passes through the emission hole 102a on the front face and extends in approximately the Y direction (front-and-rear direction). The radiation R is extracted along the emission axis EA and emitted through the emission hole 102a toward the front side. Further, in this embodiment, the energy beam EB is set to allow an incident axis IA to extend from the incident hole 102b in the right side face toward the rear side at an oblique angle to the left.

As shown in Fig. 1, the beam source 108 that emits the energy beam EB is disposed outside the enclosure 102. The beam source 108 is disposed to allow the energy beam EB to enter the inside of the enclosure 102 along the incident axis IA. Examples of the energy beam EB include an electron beam and a laser beam. The beam source 108 may employ any configurations capable of emitting these energy beams EB.

The light source apparatus 100 is provided with a chamber section C that includes a plurality of chambers. Specifically, the chamber section C includes the vacuum chamber 103, the energy beam incident chamber (hereinafter, referred to simply as the "incident chamber") 104, and the radiation emission chamber (hereinafter, referred to simply as the "emission chamber") 105. The vacuum chamber 103 and the incident chamber 104 are connected to each other, and the vacuum chamber 103 and the emission chamber 105 are connected to each other.

The incident chamber 104 is formed to be located on the incident axis IA of the energy beam EB, and the emission chamber 105 is formed to be located on the emission axis EA of the radiation R. Further, the vacuum chamber 103 is provided with the plasma generation mechanism 106 that generates the plasma P.

In this embodiment, the chamber section C (the vacuum chamber 103, the incident chamber 104, and the emission chamber 105) includes a chamber body 109, an outer protrusion 109a protruding from the front face of the chamber body 109 toward the front side, and two inner protrusions 109b and 109c protruding inward from the inner circumferential face of the chamber body 109. As the material of the chamber body 109, a metal material is used.

The chamber body 109 is configured such that its external shape is approximately a rectangular parallelepiped shape, and has its front, rear, left, and right faces that are arranged to face the front, rear, left, and right faces of the enclosure 102, respectively. The chamber body 109 has a right-front corner that is disposed to be on the incident axis IA of the energy beam EB, the right-front corner being located between the front face and the right side face.

As shown in Fig. 1, an emission hole 109d is formed in the front face of the chamber body 109. The emission hole 109d is formed along the emission axis EA of the radiation R and in line with the emission hole 102a in the front face of the enclosure 102. The outer protrusion 109a is formed to protrude from the circumferential edge portion of the emission hole 109d in the chamber body 109 toward the front side. The outer protrusion 109a is configured to protrude more forward than the emission hole 102a of the enclosure 102 with being inscribed in the emission hole 102a of the enclosure 102.

An inner protrusion 109b is formed to protrude inward from the circumferential edge portion of the emission hole 109d inside the chamber body 109. The space surrounded by the outer protrusion 109a and the inner protrusion 109b serves as the emission chamber 105. The outer protrusion 109a and the inner protrusion 109b themselves, which are the components constituting the emission chamber 105, can also be referred to as the emission chamber. The outer protrusion 109a and the inner protrusion 109b may be formed integrally with the chamber body 109, or they may be formed separately and then connected to the chamber body 109. Further, the inner protrusion 109b does not necessarily need to be provided.

The emission chamber 105 is configured to have a cone shape with its central axis being aligned with the emission axis EA of the radiation R. The emission chamber 105 is configured to have a large cross-sectional area at its center portion in the direction of the emission axis EA of the radiation R, and have the cross-sectional area being decreased toward the front and rear ends. That is, the emission chamber 105 has a shape that narrows toward the front and rear ends. The emission chamber 105 is provided with an opening (aperture) through which the radiation R passes at the front and rear ends.

A utilization device such as a mask inspection device is connected to the end portion of the emission chamber 105 on the front side (end portion of the outer protrusion 109a on the front side). In the example shown in Fig. 1, an application chamber 110 is connected as a chamber constituting part of the utilization device. The pressure inside the application chamber 110 may be an atmospheric pressure. The inside of the application chamber 110 may be purged with gas (e.g., inert gas) from a gas injection channel as necessary. The gas inside the application chamber 110 may be exhausted by an exhaust means, which is not shown in the figure.

A filter film 111 for physically separating a region where the plasma P is generated and the application chamber 110 from each other is provided between the emission chamber 105 and the application chamber 110. The filter film 111 has a structure that allows the radiation R to be transmitted therethrough and prevents the plasma raw material 101 and debris that are scattered when the plasma P is generated from entering the application chamber 110.

A collector (focusing mirror) 112 for guiding and focusing the radiation R that has entered the emission chamber 105 into the utilization device (inside of the application chamber 110) is disposed inside the emission chamber 105. In Fig. 1, the components of the radiation R that enter the emission chamber 105 and are focused are illustrated in hatching.

A shielding member (central occultation) 113 is disposed inside the emission chamber 105. The shielding member 113 is located in line with the emission hole 109d of the chamber body 109, the emission hole 102a of the enclosure 102, and the filter film 111 along with the emission axis EA of the radiation R. In this embodiment, the shielding member 113 can block the radiation components that are not focused by the collector 112. Note that the shielding member 113 does not necessarily need to be provided.

An incident window 114 is provided in the right-front corner of the chamber body 109. The incident window 114 is disposed along the incident axis IA of the energy beam EB and in line with the incident hole 102b in the right side face of the enclosure 102. An inner protrusion 109c is formed to protrude inside the right-front corner of the chamber body 109 along the incident axis IA of the energy beam EB from a position surrounding the incident window 114.

In the internal space of the chamber body 109, the space surrounded by the inner protrusion 109c serves as the incident chamber 104. The inner protrusion 109c and the right-front corner of the chamber body 109 themselves, which are the components constituting the incident chamber 104, can also be referred to as the incident chamber. The inner protrusion 109c may be formed integrally with the chamber body 109, or it may be formed separately and then connected to the chamber body 109.

The incident chamber 104 is configured to have a cone shape with its central axis being aligned with the incident axis IA of the energy beam EB. The incident chamber 104 is configured to have a cross-sectional area being decreased toward its end inside the chamber body 109 in the direction of the incident axis IA of the energy beam EB. That is, the incident chamber 104 has a shape that narrows toward the end inside. The incident chamber 104 is provided with an opening (aperture) through which the energy beam EB passes at the end thereinside.

A capturing mechanism is disposed to capture the scattered plasma raw material 101 and debris inside the incident chamber 104. In the example shown in Fig. 1, a rotary window 115 that is a plate-shaped rotation member for causing the energy beam EB to be transmitted therethrough and capturing the plasma raw material 101 and debris is disposed as the capturing mechanism. Rotating the rotary window 115 makes it possible to increase the substantial area of the beam transmission region of the rotary window 115 and reduce the frequency of replacement of the rotary window 115.

As shown in Fig. 1, gas injection channels 116a and 116b are respectively provided in the emission chamber 105 and the incident chamber 104, and gas is supplied to the emission chamber 105 and the incident chamber 104 from a gas supply device, which is omitted in the figure. A gas that has high transmittance to the radiation R is supplied to the emission chamber 105. A gas that has high transmittance to the energy beam EB is supplied to the incident chamber 104.

The gases to be supplied to the emission chamber 105 and the incident chamber 104 may be the same type of gas or different types of gases. For example, argon or helium can be used as a gas that has high transmittance to both the energy beam EB and the radiation R. In addition, the type of gas to be supplied to the emission chamber 105 and the incident chamber 104 is not limited. By supplying gas, it is possible to set the pressure inside the emission chamber 105 and the incident chamber 104 to a pressure higher than the pressure inside the vacuum chamber 103, and prevent debris and the like from entering.

In the internal space of the chamber body 109, the space excluding the internal space of the inner protrusion 109b, which serves as the emission chamber 105, and the internal space of the inner protrusion 109c, which serves as the incident chamber 104, serves as the vacuum chamber 103. The components themselves constituting the vacuum chamber 103 can also be referred to as the vacuum chamber.

As shown in Fig. 1, the chamber body 109 has a portion that protrudes through the through-hole 102c in the left side face of the enclosure 102 to the outside of the enclosure 102, and the portion has an end connected to an exhaust pump 117. The specific configuration of the exhaust pump 117 is not limited, and an arbitrary pump such as a vacuum pump may be used. The exhaust pump 117 exhausts the inside the vacuum chamber 103 and depressurizes the vacuum chamber 103. This suppresses the attenuation of the radiation R generated in the vacuum chamber 103. The inside of the vacuum chamber 103 is not necessarily a vacuum atmosphere, provided that it is a reduced-pressure atmosphere with respect to the incident chamber 104 and the emission chamber 105. The inside of the vacuum chamber 103 may be supplied with an inert gas.

In this embodiment, a gas outlet 118 is installed so as to extend in the right-and-left direction toward the region between the incident axis IA and the emission axis EA. The gas outlet 118 is installed on the right side face of the chamber body 109 via a seal member or the like. The gas outlet 118 is connected to a gas supply device, which is omitted in the figure, and supplies gas into the chamber body 109. In the example shown in Fig. 1, gas is sprayed from the gas outlet 118 along the right-and-left direction from the right side of the region between the incident axis IA and the emission axis EA toward the left region. This allows the debris that has been released from the plasma P to move in a direction away from the incident axis IA and the emission axis EA. The gas outlet 118 may be provided in another location in the chamber body 109 as long as it can supply gas into the chamber body 109.

The plasma generation mechanism 106 is a mechanism for generating the plasma P inside the vacuum chamber 103 and emitting the radiation R (X-rays, EUV light). As shown in Fig. 2, the plasma generation mechanism 106 includes a rotation body 120, and the energy beam EB enters the rotation body 120. The rotation body 120 is disposed inside the vacuum chamber 103 such that an irradiation position I of the energy beam EB is placed at the intersection between the incident axis IA and the emission axis EA. Details of the plasma generation mechanism 106 will be described below.

The controller 107 controls the operation of each component provided in the light source apparatus 100. For example, the controller 107 controls the operation of the beam source 108 and the exhaust pump 117. The controller 107 includes hardware circuits necessary for computers, such as CPUs and memories (RAM, ROM). A CPU loads a control program stored in a memory into a RAM and executes it to perform various processes. As the controller 107, a programmable logic device (PLD) such as field programmable gate array (FPGA), and other devices such as application specific integrated circuit (ASIC) may be used. In Fig. 1, the controller 107 is schematically illustrated as a function block. However, the controller 107 may be designed in any desired manner including the position at which the controller 107 is configured.

As shown in Fig. 1, in this embodiment, a radiation diagnosis section 119 is provided on the front side of the chamber body 109, in the region spatially connected to the vacuum chamber 103. The radiation diagnosis section 119 is disposed at a position at which the radiation R radiated in a direction different from the emission axis EA of the radiation R enters. The radiation diagnosis section 119 measures the state of the radiation R emitted from the plasma P. Here, the state of the radiation R means the physical state of the radiation R, such as intensity, wavelength, and spectrum of the radiation R. The radiation diagnosis section 119 includes a detector that detects the presence or absence of the radiation R and a measurement device that measures the output of the radiation, for example. The measurement results of the radiation diagnosis section 119 are used to diagnose the radiation R and control the operation of a raw material dropping device described below.

### [Configuration of plasma generation mechanism]

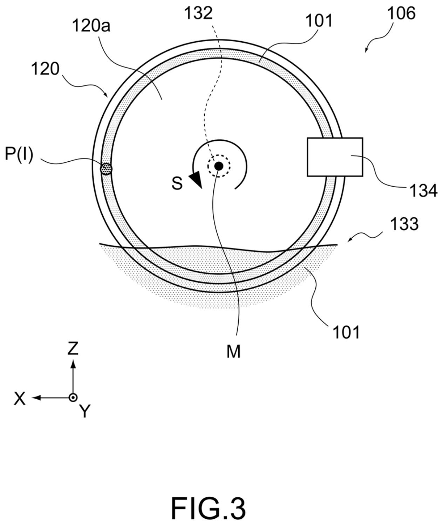

As described above, the plasma generation mechanism 106 is a mechanism for generating the plasma P inside the vacuum chamber 103 and emitting the radiation R (X-rays or EUV light). Fig. 3 is a schematic diagram of the plasma generation mechanism 106. As shown in Fig. 2 and Fig. 3, the plasma generation mechanism 106 includes the rotation body 120, a rotational drive source 131, a shaft portion 132, a reservoir 133, and a film thickness adjustment mechanism 134.

The rotational drive source 131 is disposed outside the vacuum chamber 103 and generates rotational power for the rotation body 120. The rotational drive source 131 is, for example, a motor. The shaft portion 132 penetrates the chamber body 109 and the enclosure 102 to connect the rotational drive source 131 and the rotation body 120, and transmits the rotational power generated in the rotational drive source 131 to the rotation body 120. The reservoir 133 is disposed vertically below the rotation body 120 and stores the plasma raw material 101.

The rotation body 120 is disposed inside the vacuum chamber 103 and connected to the shaft portion 132. The rotation body 120 rotates by the rotation of the shaft portion 132 as shown by an arrow S in Fig. 3. Hereinafter, the rotation axis of the rotation body 120 and the shaft portion 132 will be referred to as a rotation axis M.

As shown in Fig. 3, the rotation body 120 has a disc shape. Hereinafter, the surface of the rotation body 120 on the side opposite to the shaft portion 132 will be referred to as a rotation surface 120a. The rotation axis M is, for example, parallel to the horizontal direction (X-Y direction) and located such that the rotation surface 120a is parallel to the vertical direction. Part of the rotation surface 120a is immersed in the plasma raw material 101 stored in the reservoir 133, and the plasma raw material 101 adheres to the rotation surface 120a as it rotates. The plasma raw material 101 adhered to the rotation surface 120a is transported to the irradiation position I as the rotation body 120 rotates, and converted into plasma by the energy beam EB applied to the irradiation position I.

As shown in Fig. 3, the film thickness adjustment mechanism 134 is disposed on the rotation body 120 and adjusts the film thickness of the plasma raw material 101 adhered to the rotation surface 120a. The film thickness adjustment mechanism 134 is, for example, a structure having a channel structure, disposed so as to sandwich the rotation body 120 thereinside with a predetermined gap therebetween, and adjusts the film thickness of the plasma raw material 101 by scraping off the plasma raw material 101 that has not flowed into the gap. The film thickness adjustment mechanism 134 is provided on the upstream side of the irradiation position I in the rotational direction of the rotation body 120 and determines the film thickness of the plasma raw material 101 at the irradiation position I.

In the plasma generation mechanism 106, as described above, the plasma raw material 101 stored in the reservoir 133 adheres to the rotation surface 120a of the rotation body 120 and is transported to the irradiation position I by the rotation of the rotation body 120. Therefore, the reservoir 133 functions as a "raw material supply section" that supplies the plasma raw material 101 to the rotation surface 120a.

### [Regarding configuration of rotation body unit]

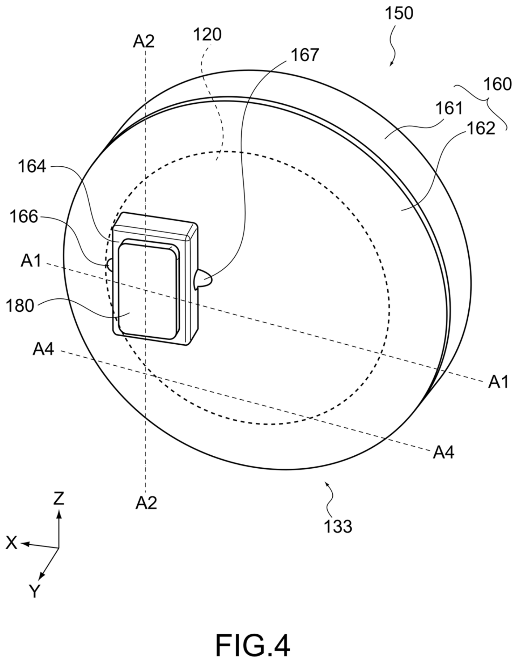

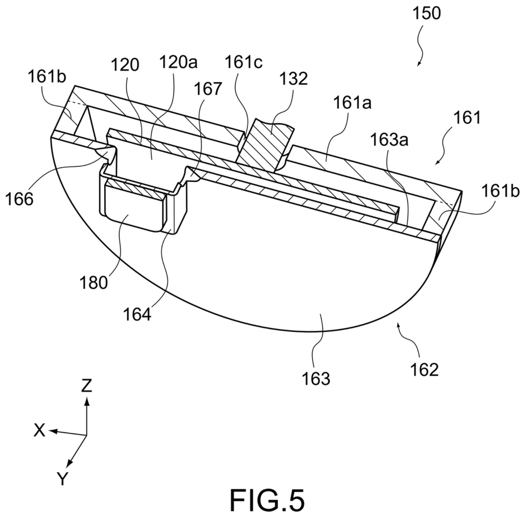

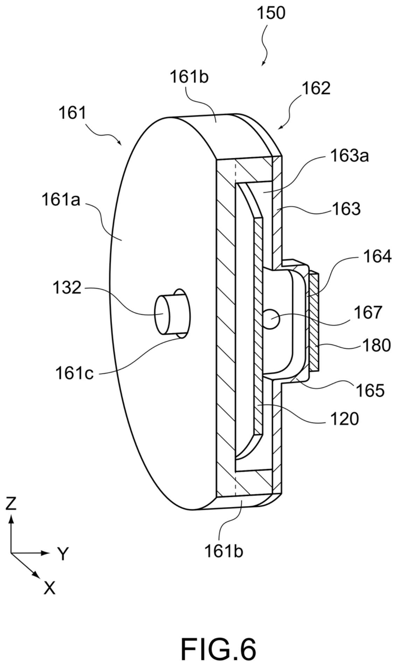

The plasma generation mechanism 106 includes a rotation body unit that houses the rotation body 120. Fig. 4 is a perspective view showing a configuration of a rotation body unit 150. As shown in the figure, the rotation body unit 150 includes the rotation body 120, a cover 160, and a heating mechanism 180, and the rotation body 120 is housed in the cover 160. Note that in Fig. 1 to Fig. 3, illustration of the cover 160 and the heating mechanism 180 is omitted. Fig. 5 and Fig. 6 are each a cross-sectional view of the rotation body unit 150. Fig. 5 is a cross-sectional view taken along the line A1-A1 (X-Y plane), and Fig. 6 is a cross-sectional view taken along the line A2-A2 (Y-Z plane) in Fig. 4.

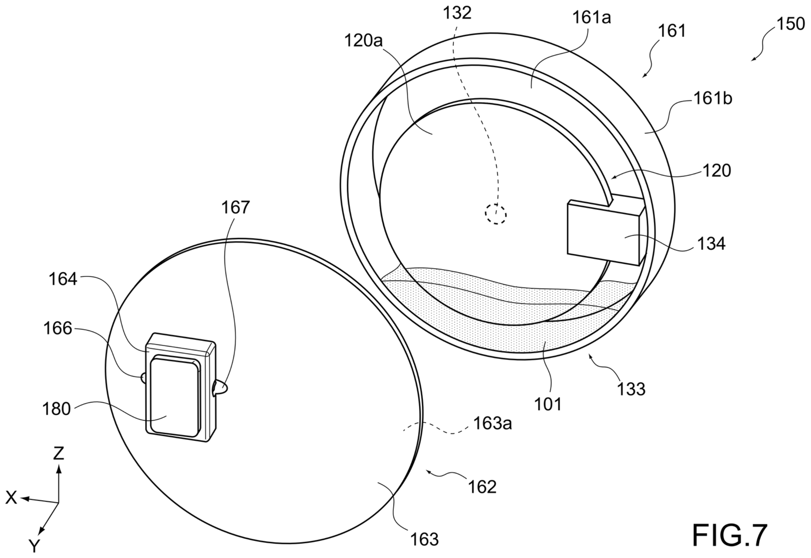

The cover 160 surrounds the rotation body 120 to prevent debris from scattering and forms the reservoir 133. The cover 160 includes a first cover member 161 and a second cover member 162. Fig. 7 is an exploded perspective view of the rotation body unit 150, showing the first cover member 161 and the second cover member 162 disassembled. As shown in the figure, the rotation body 120 is housed inside the cover 160. The plasma raw material 101 is stored in the vertically lower portion of the cover 160, and the vertically lower portion of the cover 160 forms the reservoir 133. A heating mechanism (not shown) is provided to the periphery of the reservoir 133 and heats and melts the plasma raw material 101 stored in the reservoir 133.

As shown in Fig. 7, the first cover member 161 includes a bottom portion 161a and a side wall portion 161b. The bottom portion 161a has a disc shape and is provided with a through hole 161c at the center thereof as shown in Fig. 5. The through hole 161c is a hole through which the shaft portion 132 is inserted. The side wall portion 161b has a cylindrical shape and is continuous to the peripheral edge of the bottom portion 161a.

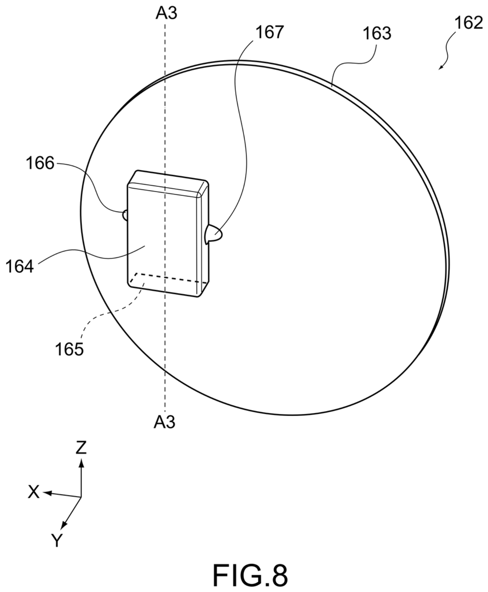

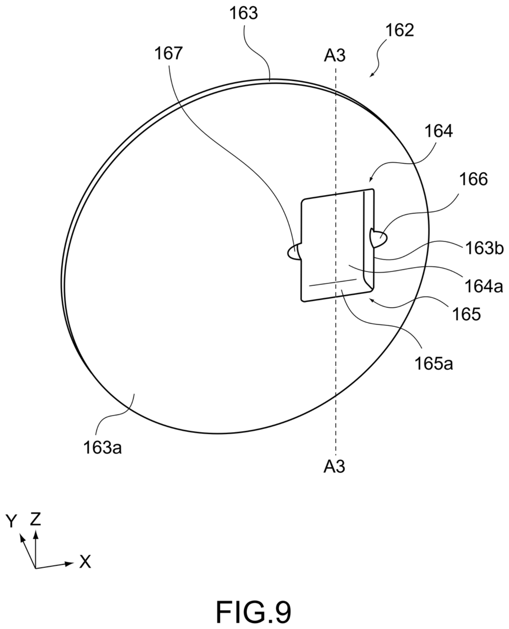

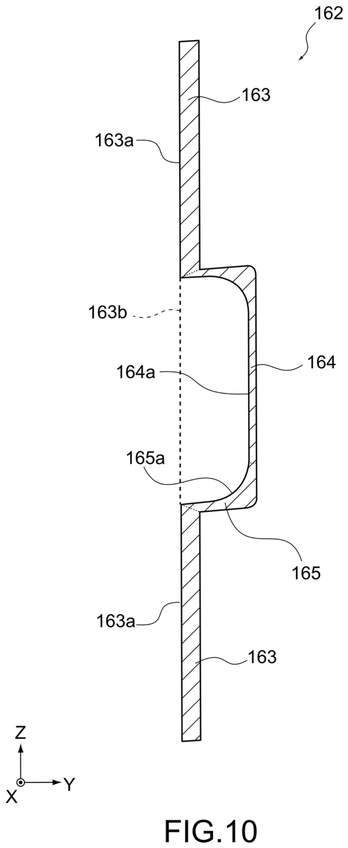

As shown in Fig. 7, the second cover member 162 is joined to the side wall portion 161b of the first cover member 161. Fig. 8 is a perspective view of the second cover member 162 when viewed from the side opposite to the rotation surface 120a, and Fig. 9 is a perspective view of the second cover member 162 when viewed from the rotation surface 120a side. Fig. 10 is a cross-sectional view of the second cover member 162, and is a cross-sectional view taken along the line A3-A3 (Y-Z plane) in Fig. 8 and Fig. 9.

As shown in Fig. 8 to Fig. 10, the second cover member 162 includes a flat plate portion 163, a shielding portion 164, and a liquid guide portion 165. The flat plate portion 163 has a flat plate shape and faces the rotation surface 120a of the rotation body 120 as shown in Fig. 7. As shown in Fig. 9, the surface of the flat plate portion 163 facing the rotation surface 120a is referred to as a facing surface 163a. The facing surface 163a is a surface parallel to the rotation surface 120a, e.g., a surface parallel to the vertical direction.

As shown in Fig. 9, the flat plate portion 163 is provided with an opening 163b, an incident hole 166, and an emission hole 167. The opening 163b is an opening formed by providing the shielding portion 164 to be recessed relative to the facing surface 163a. The incident hole 166 is a hole that is provided to penetrate the second cover member 162, the energy beam EB entering the hole. The emission hole 167 is also a hole that is provided to penetrate the second cover member 162, the radiation R being emitted from the hole.

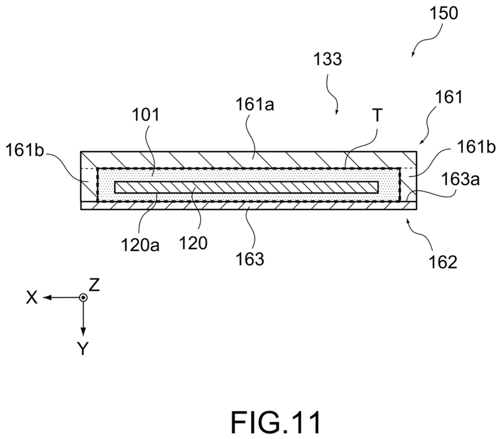

As shown in Fig. 7, the facing surface 163a forms the reservoir 133 together with the first cover member 161. Fig. 11 is a plan view of the cross section of the rotation body unit 150 when viewed from the direction (Z direction) perpendicular to the rotation axis M, and is a cross-sectional view taken along the line A4-A4 (X-Y plane) in Fig. 4. In the figure, a peripheral edge T (broken line) of the reservoir 133 is shown. The peripheral edge T is a peripheral edge of the liquid surface of the plasma raw material 101 stored in the reservoir 133. As shown in the figure, the facing surface 163a matches the peripheral edge T when viewed from the direction (Z direction) perpendicular to the rotation axis M.

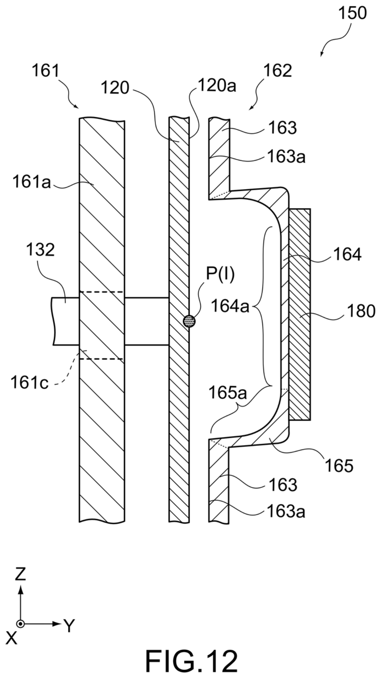

The shielding portion 164 faces the irradiation position I and shields from debris caused by plasma generation. Fig. 12 is a cross-sectional view of the vicinity of the shielding portion 164 of the rotation body unit 150 and is a cross-sectional view taken along the line of A2-A2 (Y-Z plane) in Fig. 4. As shown in the figure, the shielding portion 164 has a shielding surface 164a facing the irradiation position I of the rotation surface 120a. The shielding surface 164a is parallel to the rotation surface 120a and can be, for example, a surface parallel to the vertical direction. The shielding surface 164a may be a surface parallel to the rotation surface 120a, and may be a curved surface or an inclined surface as described below.

The shielding surface 164a is provided to be recessed from the facing surface 163a, farther away from the rotation surface 120a than the facing surface 163a, and faces the irradiation position I via the opening 163b (see Fig. 10) of the facing surface 163a. As shown in Fig. 8, the shielding portion 164 is provided with the incident hole 166 and the emission hole 167 continuously with the flat plate portion 163.

The liquid guide portion 165 is provided between the shielding portion 164 and the flat plate portion 163, and guides the plasma raw material 101 flowed in from the shielding portion 164 to the reservoir 133 that is a raw material supply section. Specifically, as shown in Fig. 12, the liquid guide portion 165 has a liquid guide surface 165a located between the shielding surface 164a and the facing surface 163a.

The liquid guide surface 165a has a shape that does not store the plasma raw material 101 flowed in from above the shielding surface 164a. Specifically, the liquid guide surface 165a has a shape that gradually approaches the rotation surface 120a from the shielding surface 164a toward the facing surface 163a. Fig. 10 shows the liquid guide surface 165a that is a curved surface. The liquid guide surface 165a may be an inclined surface as described below. Further, the entire shape of the liquid guide surface 165a does not necessarily need to gradually approach the rotation surface 120a, and at least part of the liquid guide surface 165a may be horizontal.

The heating mechanism 180 heats the shielding portion 164 to a temperature equal to or higher than the melting point of the plasma raw material 101. As shown in Fig. 12, the heating mechanism 180 is disposed on the side of the shielding portion 164 opposite to the shielding surface 164a and is in contact with the shielding portion 164. The heating mechanism 180 may also be disposed on the side of the liquid guide portion 165 opposite to the liquid guide surface 165a. Further, as the heating mechanism 180, a heating mechanism that is adjacent to the reservoir 133 and melts the plasma raw material 101 stored in the reservoir 133 may be used. The heating mechanism 180 is, for example, a resistance heater.

### [Operation and effects of light source apparatus]

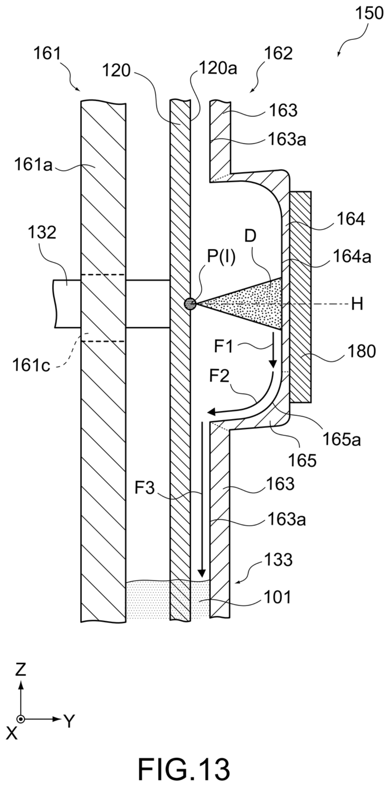

The operation and effects of the light source apparatus 100 will be described. Fig. 13 is a schematic diagram showing the operation of the light source apparatus 100. As described above, when the rotation body 120 rotates in the rotation body unit 150, the plasma raw material 101 stored in the reservoir 133 adheres to the rotation surface 120a (see Fig. 3). When the energy beam EB is emitted from the beam source 108 (see Fig. 1) in this state, the energy beam EB enters the irradiation position I on the rotation surface 120a via the incident hole 166 (see Fig. 4).

The energy beam EB converts the plasma raw material 101 into plasma at the irradiation position I to generate the plasma P as shown in Fig. 13. The radiation R (see Fig. 2) is emitted from the plasma P and emitted through the emission hole 167 (see Fig. 4). As the plasma raw material 101 is converted into plasma, debris D, which is vapor and fumes of the plasma raw material 101, belches out from the irradiation position I as shown in Fig. 13. The debris D belches out mainly along a direction H normal to the rotation surface 120a (Y direction).

Here, since the rotation body unit 150 is provided with the shielding surface 164a facing the irradiation position I, the debris D belched out from the irradiation position I reaches the shielding surface 164a. Since the shielding surface 164a is heated to a temperature equal to or higher than the melting point of the plasma raw material 101 by the heating mechanism 180, the debris D that has reached the shielding surface 164a melts and becomes a liquid plasma raw material 101, which flows down the shielding surface 164a (in the figure, arrow F1).

The plasma raw material 101 that has flowed down the shielding surface 164a flows onto the liquid guide surface 165a and flows down the liquid guide surface 165a. Since the liquid guide surface 165a has a shape that does not store the plasma raw material 101, the plasma raw material 101 flows down the liquid guide surface 165a (in the figure, arrow F2) and flows onto the facing surface 163a. The plasma raw material 101 that has flowed onto the facing surface 163a flows down the facing surface 163a (in the figure, arrow F3) and flows into the reservoir 133.

In this way, the plasma raw material 101 that has belches out as the debris D can be collected in the reservoir 133 and reused. If the shielding portion 164 is not provided, the debris D reaches a region of the second cover member 162 facing the irradiation position I, solidifies, and accumulates. In this case, there is a possibility that the accumulated debris D clogs the incident hole 166 and the emission hole 167 and causes adverse effects on the emission of the radiation R. If the debris D accumulates, the plasma raw material 101 in the amount corresponding thereto does not return to the reservoir 133, and the consumption of the plasma raw material 101 increases, making it necessary to replenish the plasma raw material 101 at short intervals.

Meanwhile, in the light source apparatus 100, since the debris D does not accumulate on the shielding surface 164a, there is no adverse effect on the radiation of the radiation R. In addition, since the plasma raw material 101 that has belched out as the debris D returns to the reservoir 133, it is possible to reduce the consumption of the plasma raw material 101 and reduce the frequency of replenishment of the plasma raw material 101.

Further, the shielding surface 164a is provided to be farther away the rotation surface 120a than the facing surface 163a (see Fig. 13). If the shielding surface 164a is close to the rotation surface 120a, there is a possibility that the plasma raw material 101 molten on the shielding surface 164a is scattered by shock waves caused by the application of the energy beam EB. In particular, although the film thickness of the plasma raw material 101 is adjusted by the film thickness adjustment mechanism 134 at the irradiation position I, there is a possibility that this film thickness fluctuates due to the scattered plasma raw material 101.

If the shielding surface 164a is close to the rotation surface 120a, there is also a possibility that the debris D that has belched out collides with the shielding surface 164a, is reflected, and adheres to the rotation surface 120a without melting. The fluctuation in the film thickness of the plasma raw material 101 at the irradiation position I and the adhesion of foreign substances can cause unstable output of the radiation R. Therefore, by providing the shielding surface 164a to be away from the rotation surface 120a, it is possible to resolve these problems and stabilize the output of the radiation R.

Note that the facing surface 163a can be made away from the rotation surface 120a together with the shielding surface 164a. However, in this case, the volume of the reservoir 133 increases and the energy necessary for melting the stored plasma raw material 101 increases. For this reason, it is suitable that the shielding surface 164a is farther away from the rotation surface 120a than the facing surface 163a.

### [Regarding shapes of shielding portion and liquid guide portion]

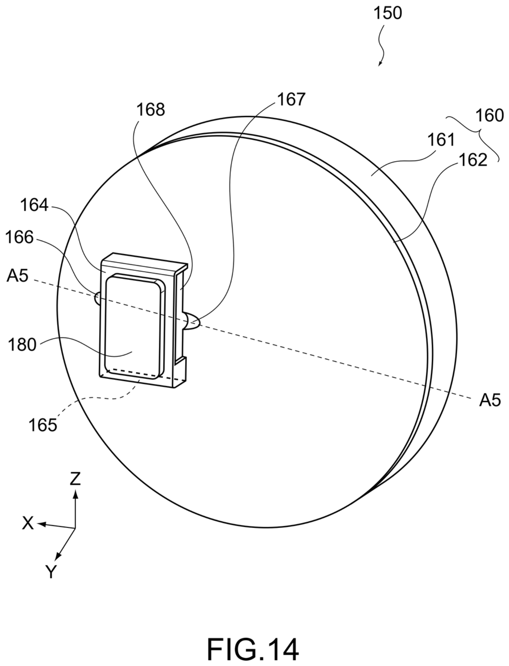

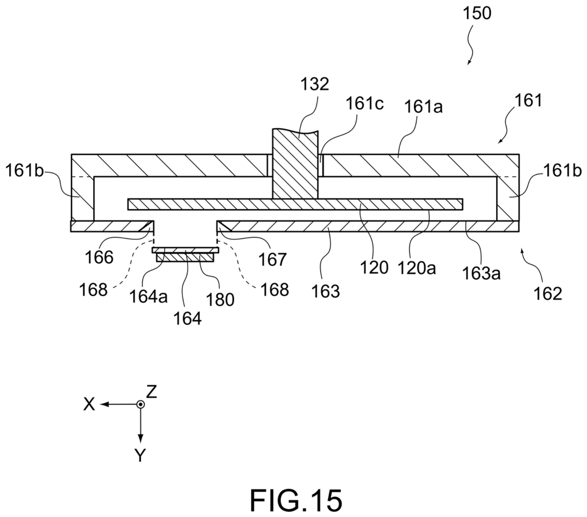

The shielding portion 164 and the liquid guide portion 165 can also have the following shapes. Fig. 14 is a perspective view of the rotation body unit 150 in which the shielding portion 164 and the liquid guide portion 165 have different shapes. Fig. 15 is a cross-sectional view of this rotation body unit 150 and is a cross-sectional view taken along the line A5-A5 (X-Y plane) in Fig. 14. As shown in these figures, a gap 168 may be provided between the shielding portion 164 and the flat plate portion 163. As described above, the debris D generated at the irradiation position I belches out mainly along the direction H (Y direction) of the rotation surface 120a (see Fig. 13). Therefore, even when the gap 168 is provided, substantially all of the debris D reaches the shielding surface 164a and is reused.

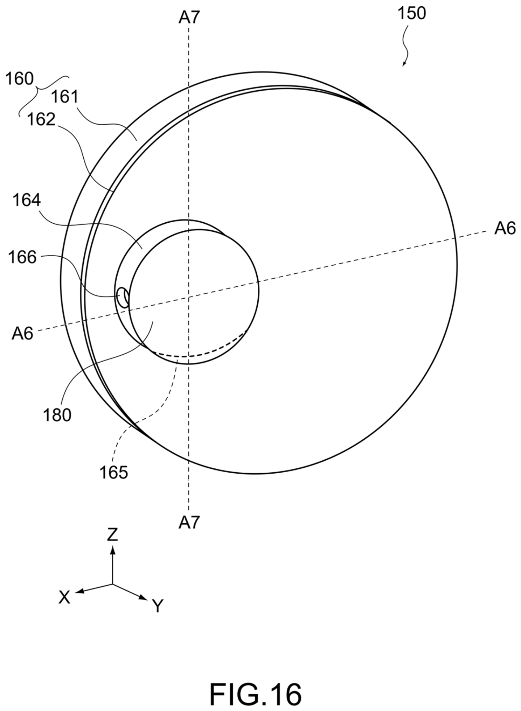

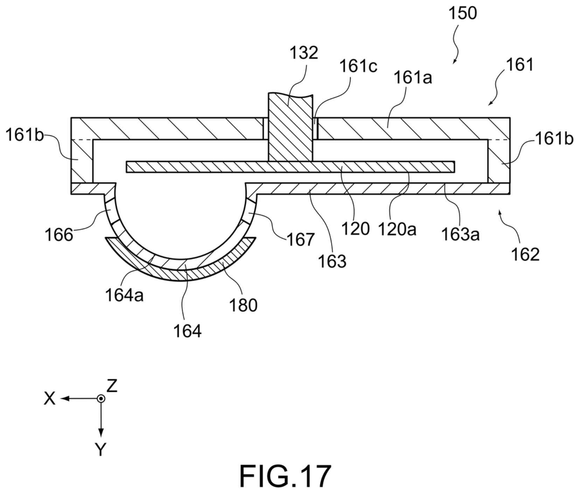

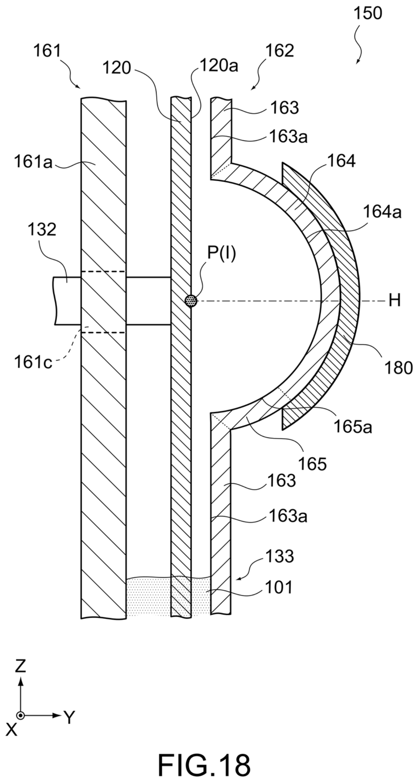

Fig. 16 is a perspective view of the rotation body unit 150 in which the shielding portion 164 and the liquid guide portion 165 have different shapes. Fig. 17 and Fig. 18 are each a cross-sectional view of this rotation body unit 150. Fig. 17 is a cross-sectional view taken along the line A6-A6 (X-Y plane) in Fig. 16, and Fig. 18 is a cross-sectional view taken along the line A7-A7 (Y-Z plane) in Fig. 14. As shown in these figures, the shielding portion 164 and the liquid guide portion 165 each have a hemispherical shape, the shielding surface 164a and the liquid guide surface 165a are hemispherical surfaces with the irradiation position I as their center. In other words, the liquid guide surface 165a is a curved surface that gradually approaches the rotation surface 120a from the shielding surface 164a toward the facing surface 163a.

In this structure, the shielding surface 164a and the liquid guide surface 165a are each located a certain distance from the irradiation position I. Since the above-mentioned shock waves caused due to the application of the energy beam EB spread isotropically, the shock waves on the shielding surface 164a and the liquid guide surface 165a can be suppressed. It is also possible to suppress the reflection of the debris D by the shielding surface 164a and the liquid guide surface 165a.

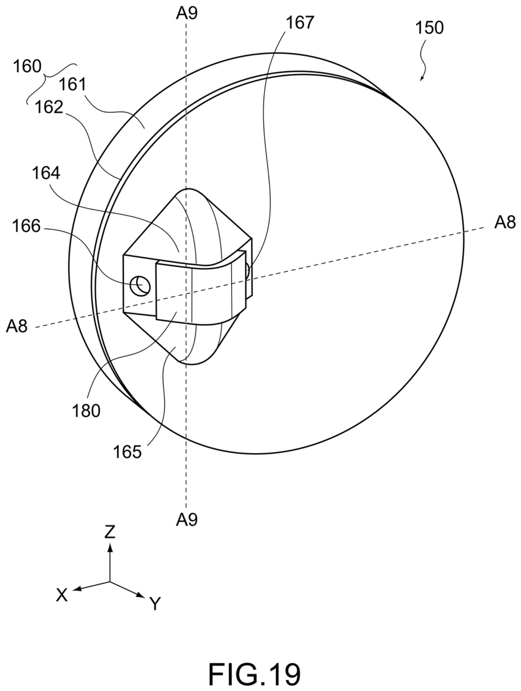

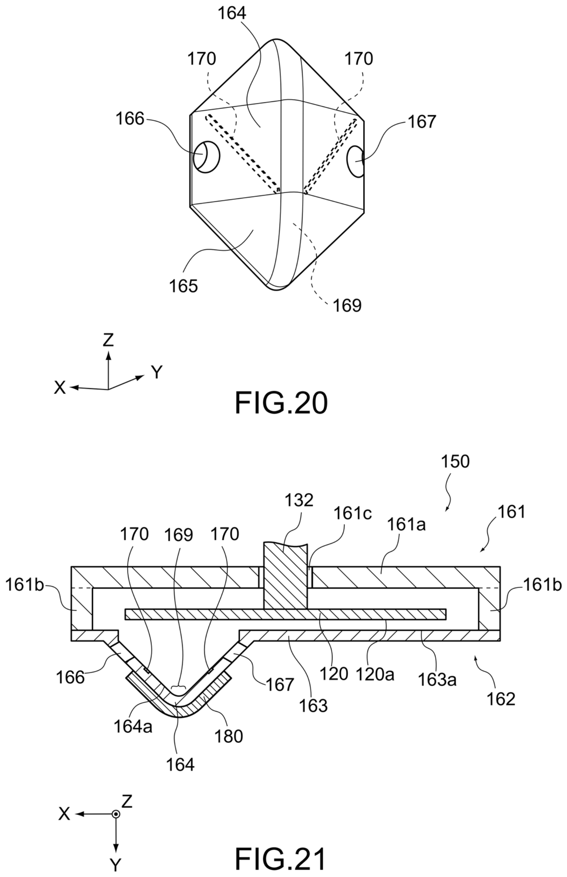

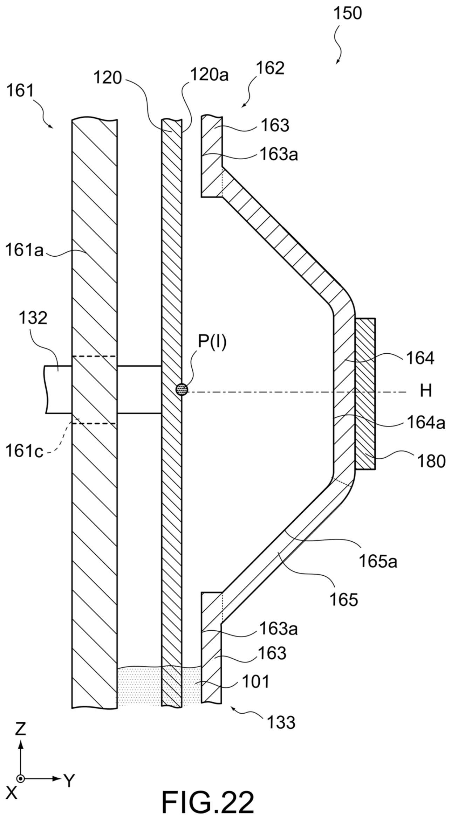

Fig. 19 is a perspective view of the rotation body unit 150 in which the shielding portion 164 and the liquid guide portion 165 have different shapes. Fig. 21 is an enlarged view of the shielding portion 164. Fig. 21 and Fig. 22 are each a cross-sectional view of this rotation body unit 150. Fig. 21 is a cross-sectional view taken along the line A8-A8 (X-Y plane) in Fig. 19, and Fig. 22 is a cross-sectional view taken along the line A9-A9 (Y-Z plane) in Fig. 19. As shown in these figures, the shielding portion 164 and the liquid guide portion 165 each have a shape mainly having a planar structure.

Specifically, the shielding surface 164a has a shape with its center farthest from the rotation surface 120a in the horizontal surface (X-Y plane). The liquid guide surface 165a is an inclined surface with its center farthest from the rotation surface 120a in the horizontal surface (X-Y plane), which gradually approaches the rotation surface 120a from the shielding surface 164a toward the facing surface 163a. Hereinafter, the valley-shaped portion farthest from the rotation surface 120a at the centers of the shielding surface 164a and the liquid guide surface 165a will be referred to as a liquid collection portion 169.

As shown in Fig. 20 and Fig. 21, the shielding surface 164a is provided with a groove 170. The groove 170 guides the plasma raw material 101 flowing along the groove 170 to the liquid guide surface 165a, and the plasma raw material 101 flowing along the groove 170 is collected in the liquid collection portion 169 and easily flows onto the facing surface 163a from the liquid collection portion 169. Adopting a shape mainly having a planar structure as the shape of each of the shielding portion 164 and the liquid guide portion 165 makes it easier to produce them. Note that although the heating mechanism 180 is provided only on the shielding portion 164 in Fig. 19, the heating mechanism 180 may also be provided on the liquid guide portion 165.

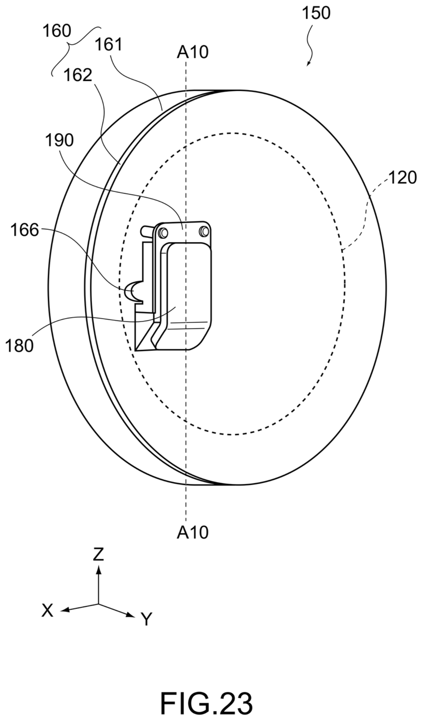

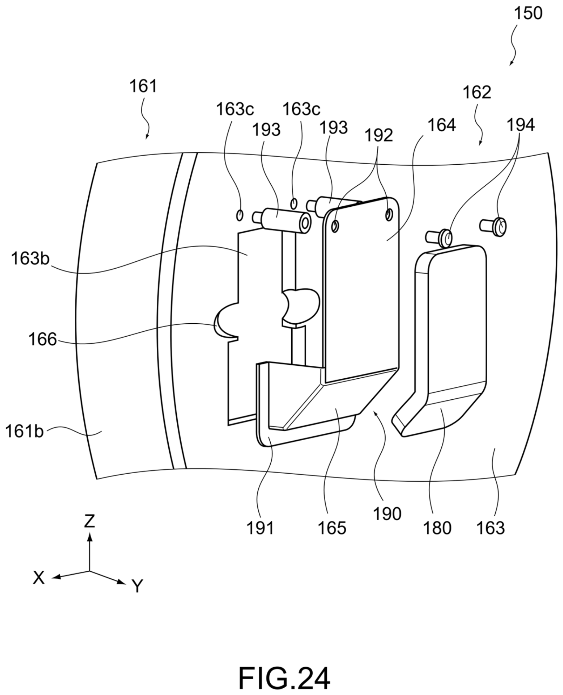

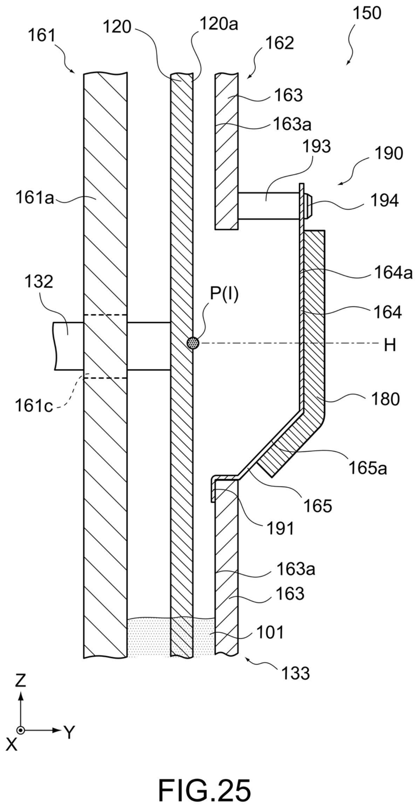

Fig. 23 is a perspective view of the rotation body unit 150 in which the shielding portion 164 and the liquid guide portion 165 have a different configuration, and Fig. 24 is an exploded perspective view of the partial configuration. Fig. 25 is a cross-sectional view of this rotation body unit 150 and is a cross-sectional view taken along the line A10-A10 (X-Y plane) in Fig. 23. As shown in these figures, the rotation body unit 150 may include a shielding body 190 attachable/detachable to/from the second cover member 162, and the shielding body 190 may include the shielding portion 164 and the liquid guide portion 165.

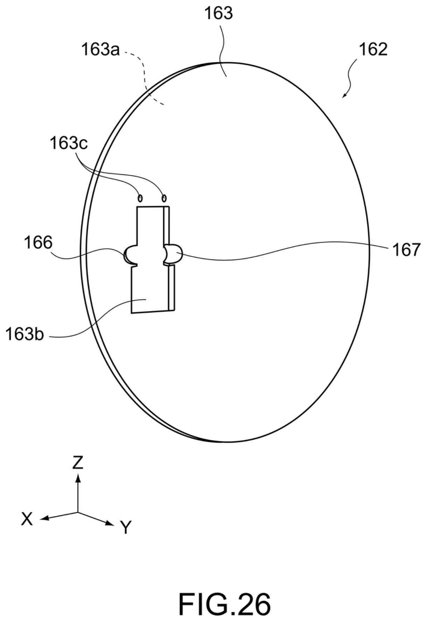

Fig. 26 is a perspective view of the second cover member 162 in this case. As shown in the figure, the second cover member 162 is not provided with the shielding portion 164 and the liquid guide portion 165, and the flat plate portion 163 is provided with the opening 163b, a through hole 163c, the incident hole 166, and the emission hole 167.

As shown in Fig. 24, the shielding body 190 includes the shielding portion 164, the liquid guide portion 165, an engaging portion 191, and a through hole 192. As shown in the figure, a stud 193 is inserted into the through hole 163c. The shielding body 190 is fixed to the second cover member 162 when the engaging portion 191 engages with the opening 163b and a screw 194 is screwed onto the stud 193 via the through hole 192. The shielding body 190 can be removed from the second cover member 162 by unscrewing the screw 194. The number of studs 192 is, for example, two, but may be one or three or more.

The engaging portion 191 is provided at the end of the liquid guide portion 165 on the side opposite to the shielding portion 164, abuts on the facing surface 163a around the opening 163b, and fixes the lower portion of the shielding body 190 to the second cover member 162. The engaging portion 191 suitably has a shape overlapping with the facing surface 163a continuously from the liquid guide surface 165a such that the plasma raw material 101 does not leak.

In this configuration, since the shielding body 190 is attachable/detachable to/from the second cover member 162, the shielding body 190 can be replaced. As described above, the shielding surface 164a is a surface that the debris belched out from the irradiation position I directly reaches, and therefore needs to be replaced at regular intervals. In this configuration, since the shielding body 190 can be replaced, making it easier to maintain.

In addition, the shielding portion 164 and the liquid guide portion 165 may have various configurations as long as the shielding portion 164 faces the irradiation position I. The liquid guide portion 165 only needs to guide the plasma raw material 101 flowed in from the shielding portion 164 to the reservoir 133. In various configurations, the shielding surface 164a may be provided with the groove 170 for guiding the plasma raw material 101 to the liquid guide surface 165a.

### (Regarding present disclosure)

In the present disclosure, in the case where the word "substantially" is used, it is used only to facilitate the understanding of description, and the use/non-use of the word "substantially" has no special meaning. That is, in the present disclosure, concepts that define shapes, sizes, position relationships, and states, such as "center", "middle", "uniform", "equal", "same", "orthogonal", "parallel", "symmetrical", "extending", "axial direction", "circular shape", "arc shape", "rectangular shape", "polygonal shape", "ring shape", "cubic shape", "rectangular parallelepiped shape", "columnar shape", "disc shape", and "cone shape", are concepts including "substantially center", "substantially middle", "substantially uniform", "substantially equal", "substantially the same", "substantially orthogonal", "substantially parallel", "substantially symmetrical", "substantially extending", "substantially axial direction", "substantially circular shape", "substantially arc shape", "substantially rectangular shape", "substantially polygonal shape", "substantially ring shape", "substantially cubic shape", "substantially rectangular parallelepiped shape", "substantially columnar shape", "substantially disc shape", and "substantially cone shape". The concepts also include concepts having states in a predetermined range (e.g., ±10% range) with respect to, for example, "exactly center", "exactly middle", "exactly uniform", "exactly equal", "exactly the same", "exactly orthogonal", "exactly parallel", "exactly symmetrical", "exactly extending", "exactly axial direction", "exactly circular shape", "exactly arc shape", "exactly rectangular shape", "exactly polygonal shape", "exactly ring shape", "exactly cubic shape", "exactly rectangular parallelepiped shape", "exactly columnar shape", "exactly disc shape", and "exactly cone shape". Therefore, even in the case where the word "substantially" is not added, a concept expressed by adding a so-called "substantially" can be included. On the contrary, the complete state is not excluded from the state expressed by adding "substantially".

In the present disclosure, expressions using "than" such as "larger than A" and "smaller than A" are expressions comprehensively including both the concept including the case where it is equivalent to A and the concept not including the case where it is equivalent to A. For example, "greater than A" is not limited to the case where it does not include "equal to A", and it also includes "equal to or greater than A". Further, "less than A" is not limited to "less than A", and it also includes "equal to or less than A". Upon the implementation of the present technology, specific settings and other settings only need to be appropriately adopted from the concepts that are included in "greater than A" and "less than A" to achieve the effects described above.

Out of the feature parts according to the present technology described above, at least two feature parts can be combined. That is, the various characteristic portions described in the respective embodiments may be arbitrarily combined with each other without distinguishing from each other in the respective embodiments. It should be noted that the effects described above are merely illustrative and are not limitative, and may have an additive effect.

### Reference Signs List

- 100: light source apparatus
- 101: plasma raw material
- 106: plasma generation mechanism
- 108: beam source
- 120: rotation body
- 131: rotational drive source
- 132: shaft portion
- 133: reservoir
- 134: film thickness adjustment mechanism
- 150: rotation body unit
- 160: cover
- 161: first cover member
- 162: second cover member
- 164: shielding portion
- 165: liquid guide portion
- 170: groove
- 180: heating mechanism
- 190: shielding body

## Claims

1. A plasma generation mechanism included in a light source apparatus that extracts radiation by converting a liquid plasma raw material into plasma by application of an energy beam, comprising:
a rotation body having a rotation surface that rotates around a rotation axis;
a rotational drive source that causes the rotation body to rotate around the rotation axis;
a raw material supply section that supplies the plasma raw material to the rotation surface;
a shielding portion that faces an irradiation position of the rotation surface to be irradiated with the energy beam;
a heating mechanism that heats the shielding portion to a temperature equal to or higher than a melting point of the plasma raw material; and
a liquid guide portion that guides, to the raw material supply section, the plasma raw material flowed in from the shielding portion.

2. The plasma generation mechanism according to claim 1, wherein
the raw material supply section includes a reservoir that stores the plasma raw material flowed in from the liquid guide portion, and
part of the rotation surface of the rotation body is immersed in the plasma raw material stored in the reservoir.

3. The plasma generation mechanism according to claim 1, wherein
the heating mechanism is disposed on the shielding portion on a side opposite to the rotation body.

4. The plasma generation mechanism according to claim 2, wherein
the heating mechanism is adjacent to the reservoir.

5. The plasma generation mechanism according to claim 1, further comprising
a cover that surrounds the rotation body and has a facing surface facing the rotation surface,
the facing surface having an opening,
the shielding portion having a shielding surface facing the irradiation position via the opening.

6. The plasma generation mechanism according to claim 5, wherein
the shielding surface is farther away from the rotation surface than the facing surface.

7. The plasma generation mechanism according to claim 6, wherein
the raw material supply section includes a reservoir that stores the plasma raw material flowed in from the liquid guide portion, and
the facing surface matches a peripheral edge of the reservoir when viewed from a direction perpendicular to the rotation axis.

8. The plasma generation mechanism according to claim 1, further comprising
a cover that surrounds the rotation body and has a facing surface facing the rotation surface,
the facing surface being located between the liquid guide portion and the raw material supply section,
the liquid guide portion causing the plasma raw material flowed in from the shielding portion to flow onto the facing surface.

9. The plasma generation mechanism according to claim 8, wherein
the shielding portion has a shielding surface facing the irradiation position, and
the liquid guide portion has a liquid guide surface that gradually approaches the rotation surface from the shielding surface toward the facing surface.

10. The plasma generation mechanism according to claim 9, wherein
the liquid guide surface is an inclined surface.

11. The plasma generation mechanism according to claim 9, wherein
the liquid guide surface is a curved surface.

12. The plasma generation mechanism according to claim 9, wherein
the shielding surface has a groove through which the plasma raw material flows.

13. The plasma generation mechanism according to claim 9, wherein
the shielding surface and the liquid guide surface are each a hemispherical surface located a certain distance from the irradiation position.

14. The plasma generation mechanism according to claim 1, further comprising:
a cover that surrounds the rotation body and has a facing surface facing the rotation surface; and
a shielding body that includes the shielding portion and the liquid guide portion and is attachable/detachable to/from the cover.

15. The plasma generation mechanism according to claim 1, further comprising
a film thickness adjustment mechanism that adjusts a film thickness of the plasma raw material on the rotation surface.

16. The plasma generation mechanism according to claim 1, wherein
the energy beam is a laser beam.

17. The plasma generation mechanism according to claim 1, wherein
the radiation is extreme ultraviolet light or X-rays.

18. The plasma generation mechanism according to claim 1, wherein
The plasma raw material is tin, lithium, gadolinium, terbium, gallium, bismuth, or an alloy including at least one of these materials.

19. A light source apparatus that extracts radiation by converting a liquid plasma raw material into plasma by application of an energy beam, comprising:
a plasma generation mechanism that includes
a rotation body having a rotation surface that rotates around a rotation axis,
a rotational drive source that causes the rotation body to rotate around the rotation axis,
a raw material supply section that supplies the plasma raw material to the rotation surface,
a shielding portion that faces an irradiation position of the rotation surface to be irradiated with the energy beam,
a heating mechanism that heats the shielding portion to a temperature equal to or higher than a melting point of the plasma raw material, and
a liquid guide portion that guides, to the raw material supply section, the plasma raw material flowed in from the shielding portion; and
a beam source that causes the energy beam to enter the irradiation position.
